Europäisches Patentamt

(19) European Patent Office

Office européen des brevets

(11) Veröffentlichungsnummer: **0 164 563**
**B1**

(12) # EUROPÄISCHE PATENTSCHRIFT

(45) Veröffentlichungstag der Patentschrifft: 21.03.90

(51) Int. Cl. ⁵: **H 05 K 13/04**, H 05 K 13/08

(21) Anmeldenummer: 85105522.8

(22) Anmeldetag: 06.05.85

(54) **Fertigungskonzept für Flachbaugruppen.**

(30) Priorität: 16.05.84 DE 3418210

(43) Veröffentlichungstag der Anmeldung: 18.12.85 Patentblatt 85/51

(45) Bekanntmachung des Hinweises auf die Patenterteilung: 21.03.90 Patentblatt 90/12

(84) Bennante Vertragsstaaten: AT BE CH DE FR GB IT LI LU NL SE

(56) Entgegenhaltungen:
BE-A-569 903
DE-A-2 839 530
US-A-3 722 062

TELEFON REPORT SIEMENS, Band 13, Nr. 3, September 1977, Selten 97-103, München, DE; W. ANDERS et al.: "Prozessrechner als Teil eines modernen Fertigungssystems für Verdrahtungen in Fernsprechanlagen der ESK-Crosspoint-Technik"

(73) Patentinhaber: Siemens Aktiengesellschaft
Wittelsbacherplatz 2
D-8000 München 2 (DE)

(72) Erfinder: Edinger, Egon, Dipl.-Ing. FH
Buchenstrasse 3
D-8033 Krailling (DE)
Erfinder: Kötter, Jachim, Dipl.-Ing.
Auenstrasse 70
D-8000 München 5 (DE)
Erfinder: Kraske, Dietmar, Ing. grad.
Schuckertstrasse 5
D-8000 München 70 (DE)
Erfinder: Krumrey, Klaus, Ing. grad.
Pulvermühlweg 396
D-6720 Speyer (DE)
Erfinder: Mayser, Jörg, Dipl.-Ing. Dipl.-Wirt.-Ing.
Dittmanns-Wiesen 4a
D-7520 Bruchsal (DE)
Erfinder: Michael, Ulrich, Dipl.-Ing.
Bergstrasse 90
D-8035 Stockdorf (DE)

EP 0 164 563 B1

## Beschreibung

Die Erfindung betrifft ein Verfahren zur automatisierten Bestückung und Prüfung elektronischer Flachbaugruppen unter Verwendung programmgesteuerter Bestückungs- und Prüfautomaten, denen die Flachbaugruppen im Zuge des Fertigungsflusses durch ein mechanisches Transportsystem zugeführt werden.

Die Senkung von Beständen und Vermeidung von technisch und dispositiv bedingter Nachrüstung bzw. Verwürfen ist ein wesentlicher Beitrag zur Steigerung der Produktivität. In besonderem Maße gilt dies für die Produktion elektronischer Anlagen, die unter Zusammensetzung hochwertiger Komponenten gefertigt werden. Schwerpunkte derartiger Betriebe ist die Flachbaugruppen-Fertigung und Prüfung.

Bestandskosten werden verursacht durch Durchlaufbestände (in direkter Abhängigkeit von der Durchlaufzeit) und Modullagerbestände an fertig geprüften Flachbaugruppen, die noch nicht von der nachgeschalteten Anlagenmontage abgerufen werden können, weil die Typenstruktur noch nicht vollständig ist. Nachrüst- und Verwurfskosten werden verursacht durch Flachbaugruppen, die nach Fertigstellung infolge geänderter Disposition nicht mehr benötigt werden bzw. zum Zeitpunkt des Bedarfs technisch überholt sind. Das Risiko steht in direkter Abhängigkeit von der Gesamtlaufzeit.

Es ist bekannt, Flachbaugruppen losweise zu fertigen, wobei der Grund für diese Losbildung darin liegt, daß zur Fertigung eines bestimmten Flachbaugruppentyps die Bestück- und Prüfmaschinen speziell gerüstet werden müssen. Zum Rüstvorgang gehört das Versorgen der Maschinen mit Material (Bauelemente) wie auch mit den Informationsmengen, die den Arbeitsablauf definieren. Weil die Rüstzeit heute im Vergleich zum eigentlichen Fertigungsprozeß relativ hoch ist, muß ersucht werden, nach Aufwendung einer Rüstzeit möglichst viele gleichartige Flachbaugruppentypen hintereinander zu fertigen (Losbildung). Bekannte Flachbaugruppenfertigungseinrichtungen fertigen in einem Zyklus von zum Beispiel mehreren Wochen das benötigte Spektrum an Flachbaugruppentypen und -mengen und liefern es an ein Flachbaugruppenlager aus, dem die nachfolgende Montagewerkstatt die Flachbaugruppen wahlfrei entnehmen kann. Dieses Pufferlager ist erforderlich, um von einem bestimmten Flachbaugruppentyp so viel Stück vorrätig zu halten, weil erst nach dem genannten Zeitraum von mehreren Wochen dieser gleiche Typ wieder gefertigt werden soll.

Die Lose fassen den Bedarf einer Periode der Anlagenmontage (zum Beispiel Monatsscheibe) zusammen. Die Fertigungs- und Prüfeinrichtungen müssen für jedes Los neu eingerichtet werden. Ein Los wird zum nachgeschalteten Produktionsschritt erst dann weitergegeben, wenn das letzte Exemplar bearbeitet ist. Die Zusammenfassung von Flachbaugruppen gleichen Typs ist eine zwingende Notwendigkeit, um die Rüstzeit in vertretbarem Verhältnis zur produktiven Zeit zu halten. Alle bekannten Aktivitäten bemühen sich um graduelle Verbesserung des heutigen Zustandes, ohne sich von der Grundbedingung der Losbildung freizumachen. Eine Durchlaufzeit in der Größenordnung von zum Beispiel zwei Wochen für die Flachbaugruppenfertigung (von Materialabruf bis zur abgeschlossenen elektrischen Prüfung) scheint eine natürliche Untergrenze zu sein. Dieser Wert ist aber nur zu erreichen, wenn die Losgröße bis an die Grenze reduziert wird, bei der der Rüstaufwand wegen seines exponentiellen Ansteigens wirtschaftlich nicht mehr vertretbar wird (Losgrößen 15 bis 20 Stück).

In der BE-A-569 903 ist ein Programmierungssystem zur Steuerung von Maschinen in der automatischen Fertigung beschrieben und dargestellt. Dabei können zuerst eingeführte Stücke in einer automatischen Maschine in eine Programmanordnung aufgenommen werden, die Programmarken trägt. Ferner ist ein Erkennungssystem an der Maschine vorgesehen, um das Programm auf den Stücken nach den Kennzeichnungsmarken abzuarbeiten.

Der Erfindung liegt die Aufgabe zugrunde, in einer möglichst kurzen Durchlaufzeit die und nur die Flachbaugruppen zu fertigen, die anschließend sofort weiterverarbeitet werden können. Hierdurch soll die Losbildung und die Bildung eines Pufferlagers, das ein komplettes einheitliches Los aufnimmt, vermieden werden.

Diese Aufgabe wird durch die in den Kennzeichen der Patentansprüche dargelegten Maßnahmen gelöst.

Die Erfindung wird anhand der Figuren erläutert. Es zeigen:

Figur 1    eine abstrakte Darstellung einer Fertigungsstrecke,

Figur 2    ein realisiertes System aufgeteilt in Figur 2a und 2b,

Figur 3    den Aufbau einer Fertigungszelle und

Figur 4    die Rolle der Rechner (hierarchisches System).

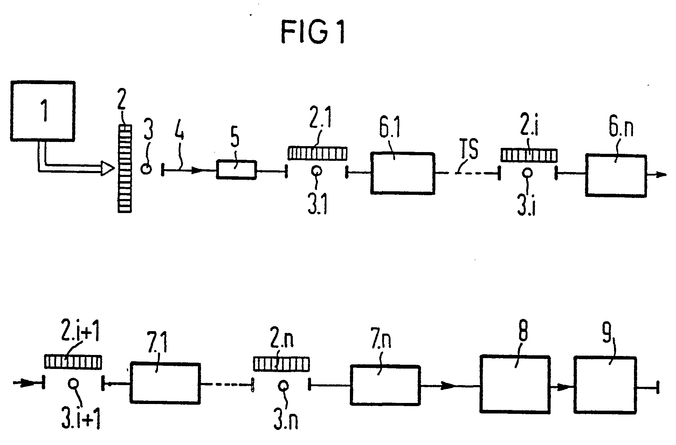

In der Figur 1 ist mit 1 ein Leiterplattenlager bezeichnet, auf das ein regalförmiger Eingangspuffer 2 folgt. Regalförmige Zwischenpuffer sind mit 2.1 - 2.n bezeichnet. Die schwarzen Punkte symbolisieren programmierbare Handhabungsgeräte, denen die Bezugszeichen 3, 3.1 - 3.n zugeordnet sind. Ein Transportband 4 verläuft durch die gesamte Fertigungsstrecke. Am Arbeitsplatz 5 erfolgt die Montage der mechanischen Teile. Daran schließt sich eine Reihe von Festigungszellen 6.1 - 6.n zur automatischen Bestückung. Im weiteren Verlauf sind Festigungszellen 7.1 - 7.n vorgesehen, an denen eine Handbestückung durchgeführt wird. Den Abschluß der Festigungsstrecke bilden eine Lötstrecke 8 und ein Prüfbereich 9.

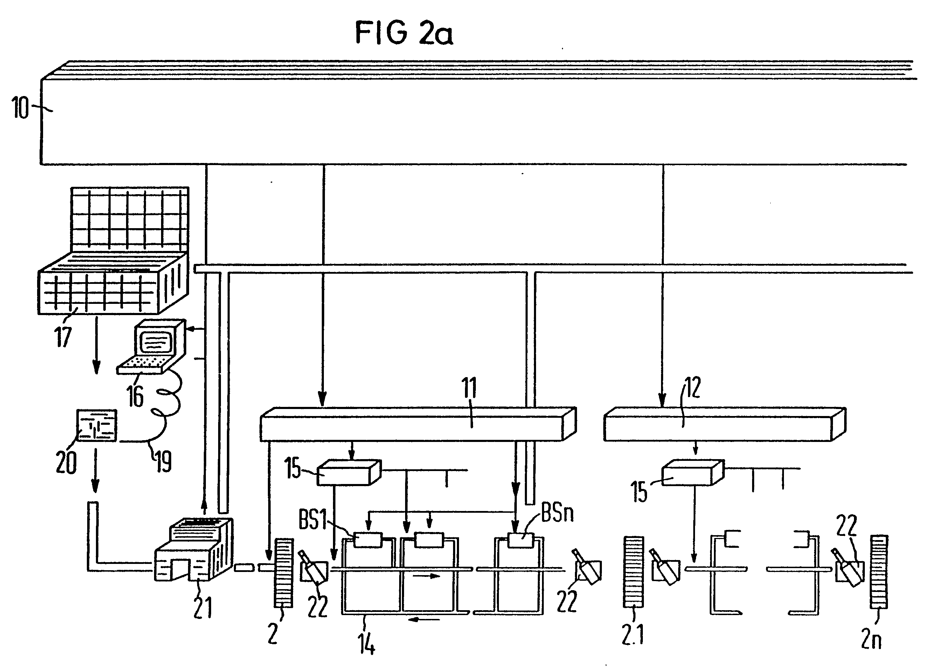

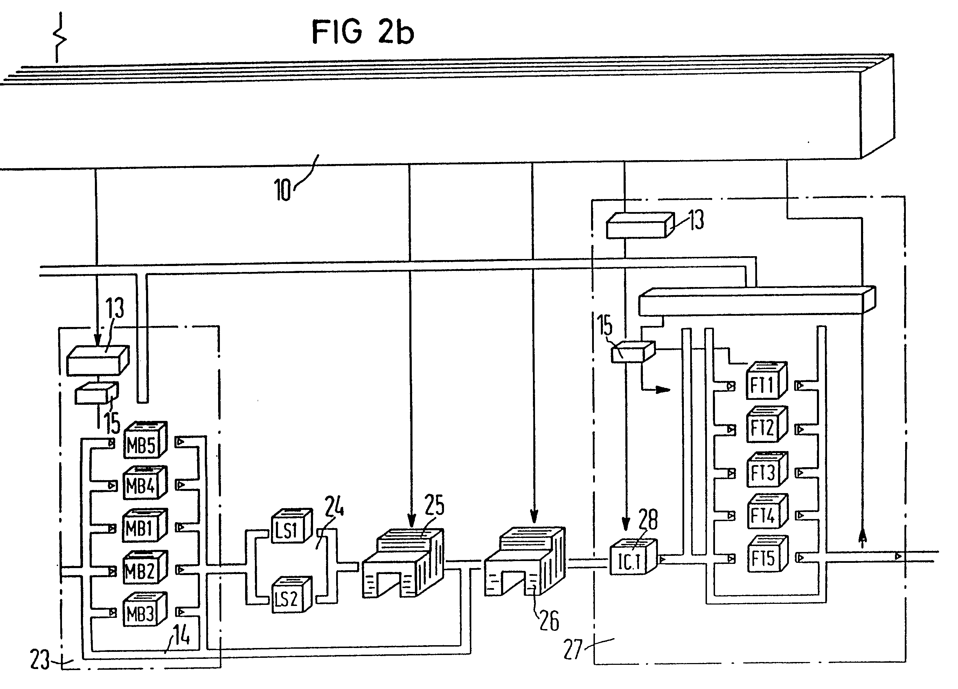

In der Figur 2 ist schematisch ein Fertigungsleitrechner 10 dargestellt, der die Koordinierung und Führung des gesamten Fertigungsprozesses beginnend von der Einspeisung der Leiterplatten bis zur Auslieferung fertig und geprüfter und gegebenenfalls reparierter Flachbaugruppen übernimmt. Zur Führung der Flachbaugruppen durch einen speziellen Bestückungsprozeß, beispielsweise mit Spezialmaschinen zur Bestückung der Flachbaugruppen mit DIP Bauelementen (im Unterschied zu Bestückmaschinen, die axiale oder radiale Bauelemente bestücken können) sind je Zelle ein eigener Zellenrechner 11 - 13 vorgesehen. Innerhalb einer Zelle sorgen Transportsysteme 14 (Förderbänder und Roboter), die von einem eigenen Transportrechner 15 gesteuert werden für eine Bewegung der Flachbaugruppen durch die Zelle. Hierfür empfängt der jeweilige Transportrechner 15 exemplarspezifische Transportaufträge vom Zellenrechner 11 bis 13 und meldet an diesen auch den Vollzug der Transportbewegung zurück.

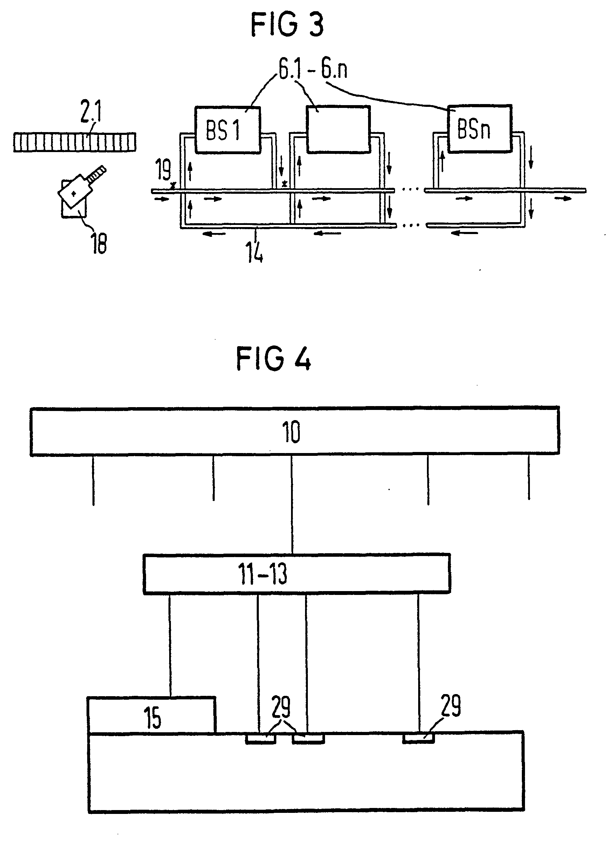

Der Fertigungsleitrechner 10 veranlaßt die Beschickung der gesamten Flachbaugruppenfertigungsstrecke dadurch, daß er über ein Terminal 16 mit Bildschirm der Reihe nach die manuelle Entnahme eines bestimmten Leiterplattentyps aus dem Leiterplattenlager 17 bestimmt. Anstelle dieses Terminals 16 kann für die Entnahme aus dem Leiterplattenlager 17 auch ein Roboter (18, Figur 3) eingesetzt werden. Mit einer Lesevorrichtung 19 wird eine das einzelne Leiterplattenexemplar 20 eindeutig identifizierende Kennung gelesen (zum Beispiel durch Lesen eines Bar-Codes). Dieses Lesen kann von Hand mittels Lesestift oder auch vollautomatisch durch einen sogenannten Scanner erfolgen.

In einer ersten Bearbeitungsstation 21 wird zum Beispiel die Leiterplatte mit Steckerleisten versehen und im vorliegenden Fall das Bar-Code-Etikett, das sich bisher nur provisorisch auf der Leiterplatte befand, auf eine bestimmte und definierte Stelle der Leiterplatte, zum Beispiel auf die Steckerleiste, gebracht.

Roboter oder mechanische Handlings-Geräte sind mit 22 bezeichnet, die die Leiterplatten aus dem Zellenpuffer 2 entnehmen und dem Bandfördersystem 14 der Zelle übergeben. BS₁ ... BSₙ sind Bestückstationen.

Mit 23 ist eine Zelle für Handbestückung bezeichnet, die auch über einen eigenen Zellenrechner 13 verfügt. Manuelle Bestückungsplätze MB1 bis MB5 sind mit einem Transportsystem 14 mit eigenem Transportrechner 15 verbunden.

An die Handbestückung 23 schließen sich eine Lötstation 24 (beispielsweise mit den Stationen LS1, LS2), eine Sichtkontrollstation 25 (SK) sowie eine PROM-Schießstation 26 (PS) an. Darauf folgt als letzte Zelle 27 im Ausführungsbeispiel die Zelle für Prüfung und Reparatur. Auf eine Bestückungsprüfstation 28 folgen Funktionsprüfstationen FT1 - FT5, die durch ein Transportsystem 14 mit eigenem Transportrechner verknüpft sind. Selbstverständlich sind die dargestellten Prüfstationen FT1 bis FT5 und die Bestückungsplätze MB1 bis MB5 nicht auf das dargestellte Ausführungsbeispiel beschränkt.

Eine Besonderheit dieser Prüfungs- und Reparaturzelle 27 ist eine besondere Fehlerlokalisierung und Reparaturstation, die allerdings auch in mehrere Teilstationen aufgeteilt werden kann. Auch zu dieser Zelle gehört ein Zellenrechner 13, der mit dem Transportrechner 15 zusammenarbeitet und aus dem heraus die Prüfstationen mit Prüfprogrammen versorgt werden.

Die Figur 3 zeigt die Verknüpfung von mehreren Bestückstationen 6 innerhalb einer Zelle durch ein gemeinsames Transportsystem 14. Angedeutet sind auch die Lesegeräte 19, mit deren Hilfe die Weichen im Transportsystem gesteuert werden.

Einen schematischen Überblick über die Rechner in diesem System gibt die Figur 4. Mit 29 sind die Maschinenrechner der einzelnen Bearbeitungsstationen dargestellt.

Der Systemaufbau wird anhand der Figur 1 beschrieben:

Die Leiterplatten werden in einer - aus der nachfolgenden Gerätemontage bekannten Typen/Stückzahl-Struktur (zum Beispiel eine Tagesproduktion) aus dem Lager 1 entnommen und in einem vor der Produktionsstrecke befindlichen Pufferregal 2 nach ihrer Identifizierungsnummer abgelegt. Die räumliche Lage der Leiterplatten in diesem Regal wird bei der Einsortierung einem Zellenrechner bekanntgegeben und dort abgespeichert. Aus dem regalförmigen Eingangspuffer 2 kann ein frei programmierbares Handhabungsgerät 3 (zum Beispiel Roboter) die Leiterplatten in beliebiger Reihenfolge entnehmen. Dieser "wahlfreie Zugriff" innerhalb der vorgegebenen Tagesmenge ermöglicht eine typenbezogene, zeitlich abgestimmte Beschickung des angekoppelten Transportsystems 4, mit dem jede Leiterplatte einzeln in einem speziellen Werkstückträger durch die gesamte Flachbaugruppenfertigung (Bestücken, Löten, Prüfen) geschleust wird. Die Reihenfolge der Beschickung wird in Abhängigkeit vom jeweils aktuellen Zustand des Regalinhaltes und der Transportbandbelegung immer wieder neu ermittelt. Dabei ist es insbesondere nicht erforderlich, gleichartige Flachbaugruppen-Typen in zusammenhängender Folge einzuschleusen.

Für das beschriebene Fertigungsverfahren ist es notwendig, jede Flachbaugruppe mit einer typ- und exemplarspezifischen Identifizierungsnummer zu versehen. Diese Nummer ist vorzugsweise direkt auf der Leiterplatte, auf einem an jeder Flachbaugruppe vorhandenen Bauelement (zum Beispiel Steckerleiste) bzw. auf dem Werkstückträger angebracht und muß automatisch erkennbar sein. Dazu bietet sich beispielsweise ein Etikett mit Bar-Code an, welches unverlierbar mit der Flachgruppe vereinigt ist.

In den nachgeschalteten Bearbeitungsstationen (Bestückautomaten, Handbestückplätze, Prüfstationen) sind mehrfach benötigte, gleichartige Produktionseinrichtungen zu sogenannten Zellen zusammengefaßt. Der Transport innerhalb einer Zelle erfolgt durch das flexible Transportsystem, welches aus einem vorgeschalteten Zellenpuffermagazin mittels eines programmierbaren Handlingsgerätes versorgt wird und nach vollständiger Abarbeitung des entsprechenden Arbeitsinhaltes die Flachbaugruppen in den Zellenpuffer der nachfolgenden Zelle entläßt.

An den einzelnen Bearbeitungsstationen (zum Beispiel Bestückautomat für axiale Bauelemente) sind die verschiedenen Bauelemente-Typen der gleichen Bauelementart (hier axiale Bauelemente) immer an der gleichen Magazinposition angeordnet. Bei einem Fehlbestückungsschritt, der als solcher von der Bearbeitungsstation erkannt und angezeigt wird, kann durch einen manuellen Eingriff die Wiederholung genau dieses Bestückungschrittes veranlaßt werden. Damit wird sichergestellt, daß beim Verlassen einer Bearbeitungsstation der darin vorgesehene Arbeitsinhalt immer 100 %ig abgearbeitet ist. Eine Umorganisierung der Magazinbelegung wird lediglich in größeren Zeitabschnitten bei gravierender Änderung der Typen/Stückzahl-Struktur vorgenommen, die durch Verschiebungen in der ABC Analyse des Bauelementbedarfs erkennbar sind.

Das flexible Transportsystem, welches alle Bearbeitungsstationen miteinander verbindet, ist so gestaltet, daß vom Zelleneingang der Eingang jeder einzelnen Station und vom Ausgang jeder Station jede andere Station angesteuert werden kann. Dies bedeutet, daß innerhalb der Zelle auch gegenläufige Verfahrwege (auf geeignet verbundenen Transportbändern) möglich sind, die es gestatten, Überholvorgänge zu realisieren, wenn dies für die homogene Arbeitsbelastung der einzelnen Bearbeitungsstationen erforderlich ist. Diese Flexiblität stellt außerordentlich hohe Anforderungen an die Leistungsfähigkeit dieses Transportsystems, um einen Materialfluß zu gewährleisten, der der jeweils aktuellen Zellensituation hinsichtlich schnellem Durchsatz und homogener Stationsbelastung gerecht wird. Zur Koordinierung all dieser Aufgaben ist die (wiederholte) Identifizierung der Flachbaugruppen auf dem Transportsystem zur Wegesteuerung einerseits und vor dem Bearbeitungsstationen zur Zuordnung der typenspezifischen Arbeitsprogramme andererseits erforderlich, wobei alle Aktivitäten im Daten-Direktverkehr im Zellen- bzw. Transportrechner abgebildet sind. Festgelegte Prioritätsregeln sorgen darüber hinaus dafür, daß Flachbaugruppen innerhalb einer Zelle, deren noch zu erledigender Arbeit-/Transportinhalt nicht optimal in das aktuelle Materialflußkonzept passen, nach einer bestimmten Anzahl von "Bewerbungen" trotzdem anerkannt und weiterverarbeitet werden.

Nach vollständiger Bearbeitung des automatischen Bestückungsvorgangs laufen die Flachbaugruppen über das bereits beschriebene Transportsystem in eine Fertigungszelle von Handbestückplätzen ein. An diesen Handbestückplätzen sind in vergleichbarer Weise alle nicht automatisch bestückbaren Bauelemente an festen Plätzen angeordnet. Die vorbestückten Flachbaugruppen werden auf dem Transportsystem (mittels Zellenrechner und Transportrechner) an all die Handbestückplätze gesteuert, an denen Bauelemente-Typen angeordnet sind, welche für diese Flachbau gruppentypen benötigt werden. In der Regel werden deshalb die Flachbaugruppen mehrerer dieser Handbestückplätze ansteuern müssen, um die Bestückung zu komplettieren. Auch an den Handbestückplätzen werden die typenspezifischen Bestückprogramme bzw. Programmteile aufgrund der Flachbaugruppen-Identifizierung aus dem Zellenrechner zur Verfügung gestellt.

Die Nachversorgung der erforderlichen Bauelemente an den Bestückautomaten und Handbestückplätzen wird innerhalb der aktiven Fertigungszeit rein verbrauchsgesteuert vorgenommen. Dabei sorgen geeignete Vorwarnsignale an den Bauelemente-Magazinen bei Erreichen des individuell programmierten Minimalbestandes dafür, daß die für den Nachversorgungsvorgang erforderliche Zeit eingehalten wird.

Der Versorgungsvorgang erfolgt "parallel", also ohne Unterbrechung des aktiven Fertigungsvorgangs, so daß kein Zeitverlust durch "Versorgen" entsteht.

Nach Abschluß der kompletten Bestückung laufen alle Flachbaugruppen über die gemeinsame Lötstrecke, um an deren Ende in den Zellenpuffer der Prüfzelle abgelegt zu werden. In der Prüfzelle wiederholen sich sinngemäß die Vorgänge wie in den vorher beschriebenen Bearbeitungszellen. Als fehlerhaft erkannte Flachbaugruppen werden dabei aus der betreffenden Prüfstation in eine Reparaturstation eingeschleust, in welcher die Fehlersuche und Reparatur vorgenommen wird. Nach einer durchgeführten Reparatur läuft die Flachbaugruppe wieder an geeigneter Stelle in die betreffende Prüfstation. Erst bei komplett geprüfter Funktionstüchtigkeit verläßt die Flachbaugruppe die Prüfzelle und wird im Leitrechner als zur Weiterverwendung verfügbar quittiert.

Als nicht reparierbar beurteilte Flachbaugruppen werden als zusätzlicher Bedarf wieder in das Fertigungssystem aufgegeben, nach dem geeignete Verfügbarkeitskontrollen (alle Teile und Bauelemente vorhanden) den Auftragsstart freigegeben haben.

Die im genannten Produktionsprozeß zur Verfügung stehenden Daten werden in MDE-Systemen (Maschinen-Daten-Erfassung) erfaßt, um System- oder produktspezifische Schwachstellen erkennen und gezielt beheben zu können.

**Patentansprüche**

1. Verfahren zur automatisierten Bestückung und Prüfung elektronischer Flachbaugruppen unter Verwendung programmgesteuerter Bestückungs- und Prüfautomaten, denen die Flachbaugruppen im Zuge des Fertigungsflusses durch ein mechanisches Transportsystem zugeführt werden, *dadurch gekennzeichnet*, daß ein Leitrechner (10) durch Anweisungen an ein BildschirmTerminal (16) oder mechanisches Handlingsgerät die manuelle oder mechanische Entnahme einzelner Leiterplattentypen aus einem Fach des Leiterplattenlagers (17) veranlaßt, wobei

- mittels eines zum Bildschirm-Terminal oder Handlingsgerät gehörenden Lesegerätes (19) eine für den Leitrechner bis zu diesem Entnahmezeitpunkt noch unbekannte exemplarspezifische Kennzeichnung der einzelnen Leiterplatte erfaßt wird, .
- diese dem Leitrechner bereits vorher bekannte Kennzeichnung dem Typ der Leiterplatte (20) zugeordnet wird und
- dem Leitrechner der Zugriff auf einen bestimmten Leiterplattentyp ermöglicht wird und

mittels eines mechanischen Transportsystems (4) dieser Leiterplattentyp nachfolgenden Bearbeitungsstationen zum Bestücken, Löten, Prüfen, zur Fehlerlokalisierung und zum Reparieren zuführbar ist.

2. Verfahren nach Anspruch 1, *dadurch gekennzeichnet*, daß mehrere, insbesondere technologisch gleichartige Bearbeitungsstationen (zum Beispiel Bestück- oder Prüfautomaten) zu sogenannten Zellen zusammengefaßt sind, denen ein eigener Zellenrechner (11 – 13) zugeordnet ist, der die einzelnen Leiterplatten (20) bzw. Flachbaugruppen nach Maßgabe eines Typ-spezifischen Arbeitsprogramms den einzelnen Bearbeitungstationen innerhalb einer Zelle zuführt, sich hierbei eines zelleneigenen, durch einen weiteren Rechner (15) gestützten Transportsystems 84) bedient, und der auch die Bearbeitungsstationen mit den typspezifischen Bearbeitungsprogrammen (zum Beispiel Bestück-, Prüf- oder Fehlerstückprogrammen) elektrisch versorgt.

3. Verfahren nach Anspruch 2, *dadurch gekennzeichnet*, daß die einzelnen Bearbeitungsstationen oder Zellen im Zuge des Fertigungsflusses durch ein mechanisches Transportsystem (TS) verbunden sind, das die aus einer Bearbeitungsstation oder Zelle austretenden einzelnen Flachbaugruppen zügig dem Eingang der nachfolgenden Bearbeitungsstation oder Zelle zuführt.

4. Verfahren nach Anspruch 1 und 3, *dadurch gekennzeichnet*, daß das rechnergeführte Transportsystem innerhalb einer Zelle die in die Zelle einlaufende einzelne Flachbaugruppe mittels eines Lesegerätes (19) exemplarspezifisch identifiziert, dies durch eine Transporteingangsmeldung dem Zellenrechner (11 – 13) mitteilt und dieser sodann anhand einer ihm vom Fertigungsleitrechner (10) elektrisch übertragenen Zuordnungsliste aus der exemplarspezifischen Kennzeichnung zum typspezifischen Arbeitsprogramm findet, aus dem er die als nächstes Ziel anzulaufende Bearbeitungsstation der Zelle erkennt und daraus einen exemplar-spezifischen Transportauftrag an den Rechner des Transportsystems bildet und elektrisch übermittelt.

5. Verfahren nach Anspruch 4, *dadurch gekennzeichnet*, daß nach Beendigung des Arbeitsvorganges an einer Bearbeitungsstation der Transportrechner (15) den Ausstoß aus dieser Station erfaßt, dies dem Zellenrechner (11 – 13) meldet und dieser sodann aus dem typspezifischen Arbeitsprogramm das nächste Ziel innerhalb der Zelle ermittelt und den entsprechenden Transportauftrag bildet.

6. Verfahren nach Anspruch 5, *dadurch* gekennzeichnet, daß das Transportsystem (4) automatische Lesegeräte (Scanner) (19) enthält, die an allen Positionen vorhanden sind, an denen die Position einer Flachbaugruppe dem Zellenrechner (11 – 13) übermittelt werden muß oder an denen im Zuge der Ausführung eines Transportauftrages eine exemplarspezifische Transportrichtungsänderung (Weiche) erfolgen muß.

7. Verfahren nach Anspruch 6, *dadurch gekennzeichnet*, daß am Eingang einer Zelle ein Puffer zur Aufnahme einer Anzahl von Flachbaugruppen vorhanden ist, über den vorübergehende Stauungen im Fertigungsfluß abgefangen werden können und aus dem das Transportsystem wahlfrei - sei es durch Anweisung vom Zellenrechner oder aufgrund einer eigenen Entscheidung einzelne Flachbaugruppen entnehmen und den Bearbeitungsstationen innerhalb der Zelle zuführt.

8. Verfahren nach Anspruch 1 bis 7, *dadurch gekennzeichnet*, daß alle Zellenrechner eine elektrische Verbindung zum überlagerten Leitrechner (10) haben, über die dem Leitrechner Meldungen über den Arbeits-Belastungszustand der Zellen übermittelt werden, aus denen der Leitrechner die Entnahmefrequenz von Leiterplatten aus dem Puffer (17) drosseln oder erhöhen kann oder aufgrund derer er die Arbeitsgeschwindigkeit der Zellen durch Befehle an die Zellenrechner verändert.

9. Verfahren nach Anspruch 8, *dadurch gekennzeichnet*, daß der Leitrechner (10) elektrisch an einen ihm übergeordneten weiteren Rechner (zum Beispiel Großrechner) angeschlossen ist, von dem der Leitrechner Listen über die zu fertigenden Flachbaugruppen empfängt und an den der Leitrechner Rückmeldungen über die vollzogene Auftragsabwicklung, Stillstandszeiten, Bauelementeverbrauch gibt.

10. Verfahren nach Anspruch 9, *dadurch gekennzeichnet* daß der Leitrechner (10) anhand einer für jeden zu fertigenden Flachbaugruppentyp hinterlegten Liste für einen Fertigungszeitraum (zum Beispiel 8 Stunden-Schicht) aus der Menge der in diesem Zeitraum zu fertigenden Flachbaugruppen die auf die einzelnen Bearbeitungsstationen entfallende Belastung ermittelt und die Reihenfolge der zu fertigenden Flachbaugruppen allein unter den Gesichtspunkten einer möglichst gleichmäßigen Belastung der Bearbeitungsstationen sowie der kürzest möglichen Durchlaufzeit für das gesamte Kollektiv eines Fertigungszeitraums (zum Beispiel 8 Stunden-Schicht) nach dem Prinzip des möglichst häufigen Typwechsels berechnet.

## Claims

1. Method for automatically assembling and testing electronic card modules using program-controlled automatic assembly and test equipment, to which the card modules are fed in the course of the production flow by a mechanical transport system, characterized in that a master computer (10) brings about the manual or mechanical removal of individual types of printed circuit board from a compartment of the printed circuit board store (17) by means of instructions to a visual display terminal (16) or mechanical handling equipment,

- an identification code on the individual printed circuit board which is specific to it and which is still unknown to the master computer until the time of this removal being detected by means of a reading device (19) belonging to the visual display terminal or handling equipment,
- this identification code which is previously known to the master computer being assigned to the type of the printed circuit board (20) and
- the master computer being provided with access to a particular printed circuit board type and it then being possible by means of a mechanical transport system (4) to feed this printed circuit board type to subsequent processing stations for assembly, soldering, testing, fault location and repairs.

2. Method according to Claim 1, characterized in that a plurality of, in particular technically identical processing stations (for example automatic assembly or test equipment) are collected in so-called cells, which have their own cell computer (11 - 13) assigned to them, which feeds the individual printed circuit boards (20) or card modules to the individual processing stations within a cell according to the instructions of a type-specific working program, in this respect uses the cell's own transport system (84) supported by at further computer (15), and which also supplies the processing stations with the type-specific processing programmes (for example assembly, testing or error location programs) in electrical form.

3. Method according to Claim 2, characterized in that the individual processing stations or cells are connected in the course of the production flow by a mechanical transport system (TS) which promptly feeds the individual card modules emerging from a processing station or cell to the input of the subsequent processing station or cell.

4. Method according to Claim 1 and 3, characterized in that, within a cell, the computer-controlled transport system specifically identifies the individual card module entering the cell by means of a reading device (19), reports this by means of a transport input report to the cell computer (11 - 13) and the latter, by referring to an allocation list transferred electrically to it from the production control computer (10), finds ... (lacuna) from the identification code specific to the card module for the type-specific working program, from which it recognizes the processing station of the cell which is to be the next destination and from this forms a transport order, which is specific to the card module, to the computer of the transport system and transfers it electrically.

5. Method according to Claim 4, characterized in that, after completion of the operational process at a processing station the transport computer (15) detects the ejection from this station, reports this to the cell computer (11 - 13) and this then ascertains the next destination within the cell from the type-specific working program and forms the corresponding transport order.

6. Method according to Claim 5, characterized in that the transport system (4) contains automatic reading devices (scanner) (19) which are present at all positions at which the position of a card module must be transferred to the cell computer (11 - 13) or at which, in the course of the execution of a transport order, a change in transport direction specific to a card module (switching point) must occur.

7. Method according to Claim 6, characterized in that, at the input to a cell a buffer is present for receiving a number of card modules, via which buffer temporary congestion in the production flow can be intercepted and out of which buffer individual card modules can be optionally removed by the transport system – either through the instructions from a cell computer or due to its own decision – and fed to the processing stations within the cell.

8. Method according to Claim 1 to 7, characterized in that all cell computers have an electrical connection to the higher-ranking master computer (10), via which reports on the state of the workload of the cells are transferred to the master computer, on the basis of which reports the master computer can reduce or increase the removal frequency of printed circuit boards from the buffer (17) or due to which reports the master computer changes the working speed of the cells by commands to the cell computers.

9. Method according to Claim 8, characterized in that the master computer (10) is electrically connected to a further computer (for example a mainframe computer) which is higher-ranking than it, from which the master computer receives lists on the card modules to be produced and to which the master computer sends acknowledgements in respect of completed execution of orders, idle times, consumption of components.

10. Method according to Claim 9, characterized in that the master computer (10), by referring to a list deposited for each card module type to be produced, ascertains for a production period (for example an 8-hour shift) the load processing incurred by the individual stations from the amount of card modules to be produced in this period and calculates the sequence of the card modules to be produced solely with a view to achieving as even as possible a loading of the processing stations and the shortest possible processing time for the entirety of a production period (for example an 8-hour shift) according to the principle of the most frequent type change possible.

**Revendications**

1. Procédé pour équiper en composants et pour contrôler, de façon automatisée, des modules plats électroniques moyennant l'utilisation d'automates, commandés de façon programmée, de montage de composants et de contrôle, auxquels les modules plats sont amenés par un système mécanique de transport, au cours du déroulement de la fabrication, caractérisé par le fait qu'un ordinateur pilote (10) déclenche, sur la base d'indications envoyées à un terminal (16) équipé d'un écran ou à un appareil mécanique de manipulation, le prélèvement manuel ou mécanique de différents types de plaquettes à circuits imprimés à partir d'un casier du magasin (17) de stockage des plaquettes à circuits imprimés, auquel cas

- une caractérisation de la plaquette à circuits imprimés individuelle, qui est spécifique pour l'exemplaire et qui est encore inconnue de l'ordinateur pilote jusqu'à cet instant de prélèvement, est détectée au moyen d'un appareil de lecture (19) associé au terminal à écran ou à l'appareil de manipulation,
- cette caractérisation déjà antérieurement connue de l'ordinateur pilote, est associée au type de la plaquette à circuits imprimés (20), et
- l'ordinateur pilote reçoit l'autorisation d'accès à un type déterminé de plaquettes à circuits imprimés, et

ce type de plaquettes à circuits imprimés peut être envoyé, au moyen d'un système mécanique de transport (4), à des postes de traitement situés en aval et utilisés pour le montage des composants, le soudage, le contrôle, la localisation de défauts et les réparations.

2. Procédé suivant la revendication 1, caractérisé par le fait que plusieurs autres postes de traitement (par exemple des automates de montage des composants ou de contrôle), qui sont notamment d'un même type technologique, sont réunis pour former ce qu'on appelle des cellules, auxquelles est associé un ordinateur (11 – 13) propre à cette cellule, qui envoie les différentes plaquettes à circuits imprimés (20) ou les différents modules plats, en fonction d'un programme de travail spécifique du point de vue du type, aux différents postes de traitement à l'intérieur d'une cellule, utilise un système de transport (84) propre à la cellule et assisté par un autre ordinateur (15), et alimente également en énergie électrique les postes de traitement, conformément aux programmes de traitement spécifiques pour le type (par exemple des programmes de montage de composants, de contrôle ou de détection de pièces défectueuses).

3. Procédé suivant la revendication 2, caractérisé par le fait que les différents postes de traitement ou cellules sont reliés, au cours du déroulement de la fabrication, par un système mécanique de transport (TS), qui envoie d'une manière uniforme les différents modules plats qui sortent d'un poste de traitement ou d'une cellule, à l'entrée du poste de traitement ou de la cellule suivante.

4. Procédé suivant les revendications 1 et 3, caractérisé par le fait que le système de transport piloté par ordinateur identifie, d'une manière spécifique à l'exemplaire, à l'intérieur d'une cellule, les modules plats individuels pénétrant dans cette cellule, à l'aide d'un appareil de lecture (19) et communiquent ce résultat au moyen d'une signalisation d'entrée de transport à l'ordinateur (11 – 13) de la cellule et ce dernier trouve alors, sur la base d'une liste d'associations qui lui est transmise par voie électrique par l'ordinateur pilote (10) conduisant la fabrication, partir de la caractérisation spécifique à l'exemplaire, le programme de travail spécifique au type à partir duquel il identifie le poste de traitement, qu'il faut atteindre en tant qu'objectif immédiatement suivant, de la cellule et forme et retransmet électriquement, à partir de là, un ordre de transport, spécifique à l'exemplaire, à l'ordinateur du système de transport.

5. Procédé suivant la revendication 4, caractérisé par le fait qu'à la fin de l'opération de travail dans un poste de traitement, l'ordinateur commandant le transport (15) détecte la sortie hors de ce poste et communique cette information à l'ordinateur (11 – 13) de la cellule et ce dernier détermine alors, à partir du programme de travail spécifique au type, l'objectif immédiatement suivant à l'intérieur de la cellule et forme l'ordre de transport correspondant.

6. Procédé suivant la revendication 5, caractérisé par le fait que le système de transport (4) contient des appareils automatiques de lecture (scanners) (19), qui sont présents dans toutes les positions dans lesquelles la position d'un module plat doit être retransmise à l'ordinateur (11 – 13) de la cellule ou auxquelles une modification de la direction de transport spécifique à l'exemplaire (aiguillage) doit être réalisée au cours de l'exécution d'un ordre de transport.

7. Procédé suivant la revendication 6, caractérisé par le fait qu'à l'entrée d'une cellule se trouve prévu, pour la réception d'un certain nombre de

13

modules plats, un tampon, qui permet d'absorber des accumulations transitoires dans le déroulement de la fabrication et dans lequel le système de transport prélève différents modules plats au choix -que ce soit sur la base d'une indication délivrée par l'ordinateur de la cellule ou sur la base d'une décision propre- et les envoie aux postes de traitement à l'intérieur de la cellule.

8. Procédé suivant les revendications 1 à 7, caractérisé par le fait que tous les ordinateurs sont reliés à l'ordinateur pilote de rang supérieur (10) par l'intermédiaire d'une liaison électrique au moyen de laquelle sont retransmises à l'ordinateur pilote, des signalisations qui concernent l'état de charge de travail des cellules et à partir desquelles l'ordinateur pilote peut réduire ou accroître la fréquence de prélèvements de plaquettes à circuits imprimés à partir du tampon (17) ou sur la base desquelles il modifie la vitesse de travail des cellules au moyen d'instructions envoyées aux ordinateurs des cellules.

9. Procédé suivant la revendication 8, caractérisé par le fait que l'ordinateur pilote (10) est raccordé électriquement à un autre ordinateur de rang supérieur (par exemple un ordinateur géant), à partir duquel l'ordinateur pilote reçoit des listes concernant les modules plats devant être fabriqués et auquel l'ordinateur pilote envoie des signalisations en retour concernant le déroulement complet des ordres, les temps d'arrêt et la consommation de composants.

10. Procédé suivant la revendication 9, caractérisé par le fait que l'ordinateur pilote (10) détermine, sur la base d'une liste mémorisée pour chaque type de module plat devant être fabriqué, pour un intervalle de temps de fabrication (par exemple une tranche de 8 heures) et à partir de la quantité des modules plats devant être fabriqués pendant cet intervalle de temps, la charge incombant aux différents postes de traitement, et calcule la succession des modules plats devant être fabriqués, uniquement du point de vue de l'obtention d'une charge aussi uniforme que possible du poste de traitement ainsi que de la durée la plus courte possible de traitement pour l'ensemble complet d'un intervalle de temps de fabrication (par exemple une tranche de 8 heures), selon le principe du changement de type le plus fréquent.

# FIG 1

# FIG 2a

EP 0 164 563 B1

# FIG 2b

EP 0 164 563 B1

# FIG 3

6.1 – 6.n

2.1

| BS 1 | | BSn |

19

18

14

# FIG 4

10

11–13

15   29   29